# DEMANDE DE BREVET EUROPEEN

(11) **EP 4 518 610 A1**
(43) Date de publication de la demande: **05.03.2025**
(21) Numéro de dépôt: 24194832.2
(22) Date de dépôt: 16.08.2024
(51) Int. Cl.: H10D 8/60, H10D 62/10, H10D 62/83

(54) **COMPOSANT VERTICAL DE PUISSANCE**

(30) Priorité: 28.08.2023 FR 2309013
(71) Demandeur: STMicroelectronics International N.V., 1228 Plan-les-Ouates, Geneva (CH)
(72) Inventeur: LANOIS, Frederic, 37100 TOURS (FR)
(74) Mandataire: Cabinet Beaumont

(57) **Abrégé**

La présente description concerne un composant vertical de puissance (300) formé dans et sur un substrat semiconducteur (101) dopé d'un premier type de conductivité et revêtu, sur sa face supérieure, d'une couche semiconductrice (103) dopée du premier type de conductivité, le composant (300) comprenant :
- une région active (100A) ;
- des premier et deuxième groupes (S1, S2) de premiers anneaux (GR) concentriques de limitation de champ entourant la région active (100A), chaque premier anneau (GR) comprenant une première région semiconductrice (105P) dopée d'un deuxième type de conductivité, opposé au premier type de conductivité, s'étendant verticalement dans l'épaisseur de la couche semiconductrice (103) depuis sa face supérieure ; et
- un deuxième anneau (LGR) de limitation de champ interposé latéralement entre les premier et deuxième groupes (S1, S2) de premiers anneaux (GR) de limitation de champ, le deuxième anneau (LGR) comprenant une deuxième région semiconductrice (305P) dopée du deuxième type de conductivité s'étendant verticalement dans l'épaisseur de la couche semiconductrice (103) depuis sa face supérieure,
dans lequel la deuxième région semiconductrice (305P) présente une largeur au moins trois fois plus importante que celle de la première région semiconductrice (105P) la plus large.

## Description

### Domaine technique

La présente description concerne de façon générale les dispositifs électroniques. La présente description concerne plus particulièrement les composants verticaux de puissance.

### Technique antérieure

Des composants verticaux de puissance ont été proposés. Parmi ces composants, des diodes JBS (de l'anglais « Junction-Barrier Schottky » - barrière de jonction Schottky) ont en particulier été proposées. Les diodes JBS présentent des avantages analogues à ceux des diodes Schottky classiques, notamment une faible chute de tension à l'état passant, une faible tension de seuil et de faibles pertes de commutation. Les diodes JBS présentent en outre, par rapport aux diodes Schottky classiques, un courant de fuite moindre et une résistance améliorée en cas de surcharge en courant.

Toutefois, les composants verticaux de puissance existants souffrent de divers inconvénients. En particulier, des arcs électriques peuvent apparaître à l'intérieur de ces composants lorsqu'ils sont soumis à des tensions inverses importantes. Les arcs électriques provoquent des dégradations irréversibles dans les composants verticaux de puissance où ils se forment, avec pour conséquence des dysfonctionnements rendant les composants au moins partiellement inopérants.

### Résumé de l'invention

Il existe un besoin de pallier tout ou partie des inconvénients des composants verticaux de puissance existants. Il existe en particulier un besoin d'éviter la formation d'arcs électriques dans les composants verticaux de puissance existants.

Pour cela, un mode de réalisation prévoit un composant vertical de puissance formé dans et sur un substrat semiconducteur dopé d'un premier type de conductivité et revêtu, sur sa face supérieure, d'une couche semiconductrice dopée du premier type de conductivité, le composant comprenant :
- une région active ;
- des premier et deuxième groupes de premiers anneaux concentriques de limitation de champ entourant la région active, chaque premier anneau comprenant une première région semiconductrice dopée d'un deuxième type de conductivité, opposé au premier type de conductivité, s'étendant verticalement dans l'épaisseur de la couche semiconductrice depuis sa face supérieure ;
- un deuxième anneau de limitation de champ interposé latéralement entre les premier et deuxième groupes de premiers anneaux de limitation de champ, le deuxième anneau comprenant une deuxième région semiconductrice dopée du deuxième type de conductivité s'étendant verticalement dans l'épaisseur de la couche semiconductrice depuis sa face supérieure,
dans lequel la deuxième région semiconductrice présente une largeur au moins trois fois plus importante que celle de la première région semiconductrice la plus large ; et
- une première région isolante située sur et en contact mécanique avec toute la face supérieure de la deuxième région semiconductrice.

Selon un mode de réalisation, le deuxième anneau permet de réduire au moins de moitié, de préférence d'au moins deux tiers, un champ électrique présent au voisinage d'une interface entre la première région isolante, disposée sur et en contact avec la face supérieure de la couche semiconductrice, et une deuxième région isolante, située dans une région périphérique du composant vertical de puissance.

Selon un mode de réalisation, le deuxième anneau permet de réduire au moins de moitié, de préférence d'au moins deux tiers, un champ électrique présent au voisinage d'une interface entre la première région isolante, disposée sur et en contact avec la face supérieure de la couche semiconductrice, et une résine de moulage d'un boîtier du composant vertical de puissance.

Selon un mode de réalisation, les premier et deuxième groupes comprennent des nombres identiques de premiers anneaux.

Selon un mode de réalisation, les premiers et deuxième anneaux de limitation de champ sont des anneaux de garde flottants.

Selon un mode de réalisation, le composant comprend en outre au moins un troisième groupe de premiers anneaux, et au moins un troisième anneau de limitation de champ interposé entre le deuxième groupe de premiers anneaux et ledit au moins un troisième groupe de premiers anneaux.

Selon un mode de réalisation, la couche semiconductrice présente un niveau de dopage strictement inférieur à celui du substrat semiconducteur.

Selon un mode de réalisation, le composant comprend :
- une première électrode de conduction formée dans la région active et comprenant une région conductrice située sur la couche semiconductrice ; et
- une deuxième électrode de conduction disposée du côté d'une face du substrat semiconducteur opposée à la couche semiconductrice.

Selon un mode de réalisation, le substrat semiconducteur est en silicium ou en carbure de silicium.

Selon un mode de réalisation, le premier type de conductivité est N et le deuxième type de conductivité est P.

Selon un mode de réalisation, le composant est une diode JBS.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A et la figure 1B sont des vues schématiques et partielles, respectivement de dessus et en coupe selon le plan BB de la figure 1A, illustrant un exemple de composant vertical de puissance ;
la figure 2 est une vue de détail, schématique et partielle, d'une région périphérique du composant vertical de puissance des figures 1A et 1B ;
la figure 3 est une vue de détail, schématique et partielle, d'une région périphérique d'un composant vertical de puissance selon un mode de réalisation ; et
la figure 4 est un graphique illustrant des variations de champ électrique et de potentiel électrostatique dans la région périphérique du composant vertical de puissance de la figure 3.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les diverses applications mettant en oeuvre des composants verticaux de puissance n'ont pas été détaillées, les modes de réalisation décrits étant compatibles avec toutes ou la plupart des applications susceptibles de tirer profit d'un ou plusieurs composants verticaux de puissance.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % près, de préférence à 5 % près.

Dans la description qui suit, les qualificatifs « isolant » et « conducteur » signifient respectivement, sauf précision contraire, électriquement isolant et électriquement conducteur.

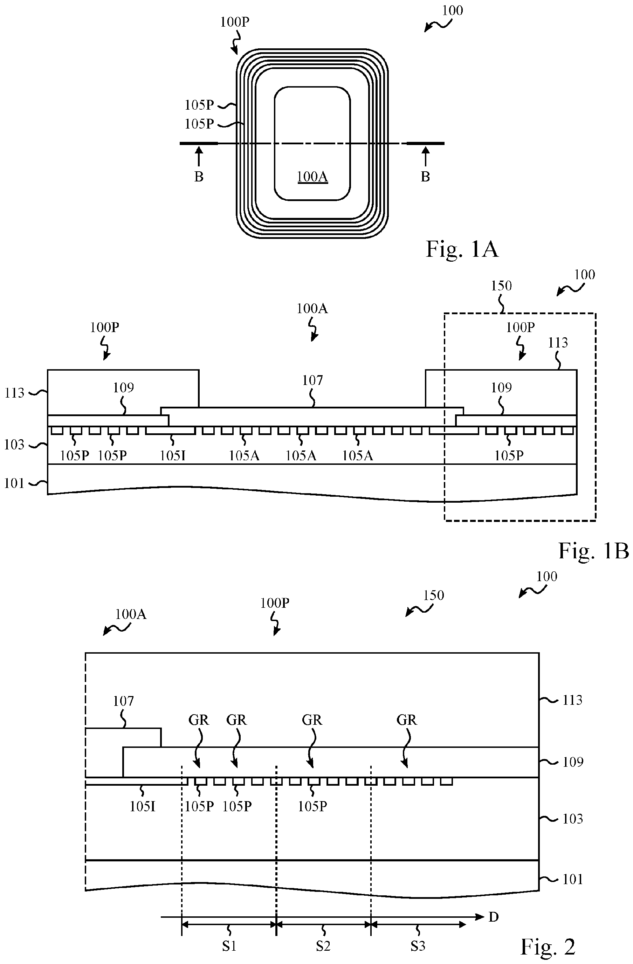

La figure 1A est une vue de dessus, schématique et partielle, illustrant un exemple de composant vertical de puissance 100. La figure 1B est une vue en coupe, selon le plan BB de la figure 1A, du composant vertical de puissance 100.

Dans l'exemple illustré, le composant vertical de puissance 100 est une diode JBS (de l'anglais « Junction-Barrier Schottky » - barrière de jonction Schottky) comprenant une région active 100A, correspondant par exemple à une région susceptible d'être parcourue par un signal de puissance lors du fonctionnement du composant. Dans cet exemple, la région active 100A du composant vertical de puissance 100 est bordée par une région périphérique 100P non destinée à être parcourue par le signal de puissance lors du fonctionnement du composant. La région active 100A est par exemple située sensiblement au centre du composant vertical de puissance 100. La région périphérique 100P du composant vertical de puissance 100 entoure la région active 100A et présente par exemple, en vue de dessus, une forme annulaire. La région périphérique 100P est interposée latéralement entre la région active 100A et le bord du composant vertical de puissance 100. La figure 1A illustre un exemple dans lequel le composant vertical de puissance 100 présente, en vue de dessus, une forme générale rectangulaire. Cet exemple n'est toutefois pas limitatif, le composant vertical de puissance 100 pouvant, à titre de variante, présenter une forme générale quelconque, par exemple carrée, ovale, circulaire, etc.

Dans l'exemple représenté, le composant vertical de puissance 100 est formé dans et sur un substrat semiconducteur 101. Le substrat 101 est par exemple une plaquette ou un morceau de plaquette en un matériau semiconducteur, par exemple le silicium (Si) ou le carbure de silicium (SiC). Le substrat semiconducteur 101 est dopé d'un premier type de conductivité, par exemple le type N, et présente par exemple un niveau de dopage compris entre 1*10¹⁷ et 5*10²⁰ at./cm³ (dopage N⁺, dans le cas où le premier type de conductivité est le type N). À titre d'exemple, le substrat semiconducteur 101 présente une épaisseur supérieure ou égale à environ 50 µm, l'épaisseur du substrat semiconducteur 101 étant par exemple choisie de sorte à assurer la tenue mécanique de la structure du composant vertical de puissance 100.

La face supérieure, dans l'orientation de la figure 1B, du substrat semiconducteur 101 est revêtue d'une couche semiconductrice 103. La couche semiconductrice 103 est par exemple en le même matériau que le substrat 101, par exemple le silicium ou le carbure de silicium. À titre d'exemple, la couche semiconductrice 103 est une couche épitaxiée, c'est-à-dire formée par croissance épitaxiale sur la face supérieure du substrat semiconducteur 101. La couche semiconductrice 103 est par exemple dopée du premier type de conductivité (le type N, dans cet exemple). La couche semiconductrice 103 présente par exemple un niveau de dopage strictement inférieur à celui du substrat semiconducteur 101, par exemple compris entre 1*10¹³ et 5*10¹⁷ at./cm³. La couche semiconductrice 103 présente par exemple un niveau de dopage et une épaisseur choisis en fonction d'une tenue en tension à atteindre par le composant vertical de puissance 100.

Dans l'exemple représenté, le composant vertical de puissance 100 comprend en outre des régions semiconductrices 105A, 105I et 105P s'étendant verticalement dans l'épaisseur de la couche semiconductrice 103 depuis sa face opposée au substrat semiconducteur 101 (la face supérieure de la couche 103, dans l'orientation de la figure 1B). Les régions semiconductrices 105A, 105I et 105P présentent une épaisseur strictement inférieure à celle de la couche semiconductrice 103. Dans l'exemple illustré, les régions semiconductrices 105A font partie de la région active 100A, et les régions semiconductrices 105I et 105P font partie de la région périphérique 100P du composant vertical de puissance 100, la région 105I étant interposée latéralement entre les régions 105A et 105P. Les régions semiconductrices 105A, 105I et 105P sont dopées d'un deuxième type de conductivité (le type P, dans cet exemple) opposé au premier type de conductivité. À titre d'exemple, les régions semiconductrices 105A, 105I et 105P présentent un niveau maximum de dopage compris entre 1*10¹⁷ et 5*10²⁰ at./cm³ (dopage P⁺, dans le cas où le deuxième type de conductivité est le type P). Les régions semiconductrices 105A, 105I et 105P sont par exemple formées par une étape d'implantation ionique, du côté de la face de la couche semiconductrice 103 opposée au substrat semiconducteur 101, suivie d'une étape de recuit. En figure 1A, les régions semiconductrices 105A et 105P n'ont pas été détaillées et seules certaines régions semiconductrices 105P (en l'espèce, trois régions semiconductrices 105P) ont été représentées afin de ne pas surcharger le dessin. Par ailleurs, les nombres de régions semiconductrices 105A et 105P peuvent être différents de ceux représentés en figures 1A et 1B. À titre d'exemple, le nombre de régions semiconductrices 105P est compris entre cinq et trois cents, par exemple compris entre dix et cinquante, par exemple égal à environ quinze.

Dans l'exemple illustré, les régions semiconductrices 105P et 105I présentent, en vue de dessus, des formes annulaires concentriques, chaque région semiconductrice 105P, 105I entourant toutes les régions semiconductrices 105A. À titre d'exemple, chaque région semiconductrice 105P, 105I présente un pourtour de forme rectangulaire à coins arrondis. Les régions semiconductrices 105A forment par exemple, en vue de dessus, des bandes parallèles entre elles et s'étendant latéralement le long d'une direction orthogonale au plan BB. À titre de variante, les régions semiconductrices 105A peuvent former, en vue de dessus, une grille comprenant des premières bandes parallèles entre elles et orthogonales au plan BB, et des deuxièmes bandes parallèles entre elles et orthogonales aux premières bandes, des formes hexagonales, des formes elliptiques ou rondes, des bandes discontinues, etc.

Dans l'exemple représenté, le composant vertical de puissance 100 comprend en outre une région conductrice 107 disposée sur et en contact avec une partie de la face supérieure de la couche semiconductrice 103 faisant partie de la région active 100A du composant 100 et avec les faces supérieures des régions semiconductrices 105A et 105I. La région conductrice 107 définit par exemple la région active 100A du composant 100. La région conductrice 107 est par exemple en un empilement métallique comprenant par exemple de l'aluminium (Al). Dans ce cas, la région 107 forme, avec la couche semiconductrice 103, un contact de type Schottky (contact métal-semiconducteur).

Dans l'exemple illustré, une région isolante 109 est disposée sur et en contact avec une partie de la face supérieure de la couche semiconductrice 103 faisant partie de la région périphérique 100P du composant vertical de puissance 100, avec les faces supérieures des régions semiconductrices 105P et avec une partie de la région semiconductrice 105I. La région isolante 109 présente par exemple, en vue de dessus, une forme annulaire entourant la région active 100A du composant 100. Dans l'exemple représenté, la région conductrice 107 se prolonge latéralement sur et en contact avec une partie de la face supérieure de la région isolante 109. La région isolante 109 fait par exemple office de couche de passivation du composant vertical de puissance 100. À titre d'exemple, la région isolante 109 est en un oxyde, par exemple le dioxyde de silicium.

Dans l'exemple illustré, le composant vertical de puissance 100 comprend en outre une autre région isolante 113 située dans la région périphérique 100P du composant 100 et disposée sur et en contact avec une partie de la face supérieure de la région conductrice 107 et avec la face supérieure de la région isolante 109. La région isolante 113 présente par exemple, en vue de dessus, une forme annulaire entourant la région active 100A du composant 100. La région isolante 113 forme par exemple une couche de passivation du composant vertical de puissance 100. À titre d'exemple, la région isolante 113 est en un matériau organique, par exemple un polymère, par exemple l'oxyde de polybutylène (« PolyButylene Oxide » - PBO, en anglais) ou le polyimide.

À titre de variante, la région isolante 113 peut être omise, la région isolante 109 étant, dans le cas d'un assemblage en boîtier moulé, en contact avec une résine de moulage.

Bien que cela n'ait pas été illustré en figures 1A et 1B, le composant vertical de puissance 100 comporte en outre une couche conductrice disposée du côté d'une face du substrat semiconducteur 101 opposée à la couche semiconductrice 103 (la face inférieure du substrat semiconducteur 101, dans l'orientation de la figure 1B). Cette couche conductrice fait par exemple partie d'une autre électrode de conduction, par exemple une cathode, du composant vertical de puissance 100. La couche conductrice revêtant la face inférieure du substrat 101 est par exemple en le même matériau que la région conductrice 107, par exemple un métal (par exemple le nickel) ou un alliage métallique.

Par ailleurs, bien que cela n'ait pas été représenté, le composant vertical de puissance 100 peut être entouré d'un boîtier, par exemple un boîtier en une résine polymère moulé autour de la structure du composant vertical de puissance 100.

La figure 2 est une vue de détail, schématique et partielle, de la région périphérique 100P du composant vertical de puissance 100 des figures 1A et 1B. La figure 2 correspond plus précisément à une vue de détail et en coupe de la région 150 délimitée par un cadre en pointillé en figure 1B.

Dans l'exemple représenté en figure 2, les régions semiconductrices 105P présentent des dimensions identiques, aux dispersions de fabrication près, et sont espacées de façon sensiblement régulière. Cet exemple n'est toutefois pas limitatif, les régions semiconductrices 105P pouvant, à titre de variante, présenter des dimensions et/ou des espacements différents. Dans ce cas, les régions semiconductrices 105P présentent par exemple des largeurs identiques et un pas variable, ou des largeurs variables et un pas constant. Les régions semiconductrices 105P de la région périphérique 100P du composant vertical de puissance 100 permettent d'étaler la zone de charges d'espace de la jonction principale, formée au niveau de l'interface entre la couche semiconductrice 103 et la région conductrice 105I, sur une distance adaptée à assurer la tenue en tension du composant 100.

Dans l'exemple illustré, les régions semiconductrices 105P font respectivement partie d'anneaux de limitation de champ (GR), par exemple des anneaux de garde flottants (« Floating Guard Rings » - FGR, en anglais), chaque anneau GR comprenant une seule région semiconductrice 105P. À titre d'exemple, les anneaux de limitation de champ GR présentent des espacements et des largeurs dimensionnés de sorte à permettre d'obtenir un champ électrique sensiblement constant au voisinage de l'interface entre les régions isolantes 109 et 113 lorsque le composant vertical de puissance 100 est soumis à une tension nominale appliquée entre ses électrodes de conduction. À titre d'exemple, la tension nominale est, en valeur absolue, supérieure ou égale à 350 V, par exemple comprise entre 600 V et 15 kV.

Dans l'exemple représenté, les anneaux de limitation de champ GR du composant vertical de puissance 100 ont été scindés en trois ensembles S1, S2 et S3, ou groupes, d'anneaux GR comprenant chacun des nombres sensiblement égaux d'anneaux GR, donc de régions semiconductrices 105P. Dans l'exemple illustré, le groupe S1 comprend les anneaux GR dont les régions semiconductrices 105P sont les plus proches de la région active 100A du composant vertical de puissance 100, le groupe S3 comprend les anneaux GR dont les régions semiconductrices 105P sont les plus éloignées de la région active 100A, et le groupe S2 comprend les anneaux GR dont les régions semiconductrices 105P sont interposées latéralement entre celles du groupe S1 et celles du groupe S3. En figure 2, un axe parallèle à la face supérieure du substrat semiconducteur 101 et au plan BB de la figure 1A et orienté depuis la région active 100A vers la région périphérique 100P du composant vertical de puissance 100, permet de repérer une distance (D) séparant chaque anneau GR, ou chaque région semiconductrice 105P, de la région active 100A.

Un inconvénient du composant vertical de puissance 100 tient au fait que des phénomènes de délamination, ou de décollement, peuvent se produire notamment entre le boîtier et le composant vertical de puissance 100, ou entre la région isolante 113 et la région isolante 109. Dans le cas où le composant vertical de puissance 100 est dépourvu de la région isolante 113, les phénomènes de délamination peuvent avoir lieu entre la région isolante 109 et la résine de moulage du boîtier. Les phénomènes de délamination conduisent à l'apparition d'une couche gazeuse, par exemple une couche d'air, dans laquelle peuvent se former des arcs électriques, par exemple lorsque le composant vertical de puissance est soumis à une forte tension inverse. Ces arcs électriques provoquent des dégradations irréversibles dans le composant vertical de puissance 100, conduisant ainsi à des dysfonctionnements rendant le composant vertical de puissance 100 au moins partiellement inopérant.

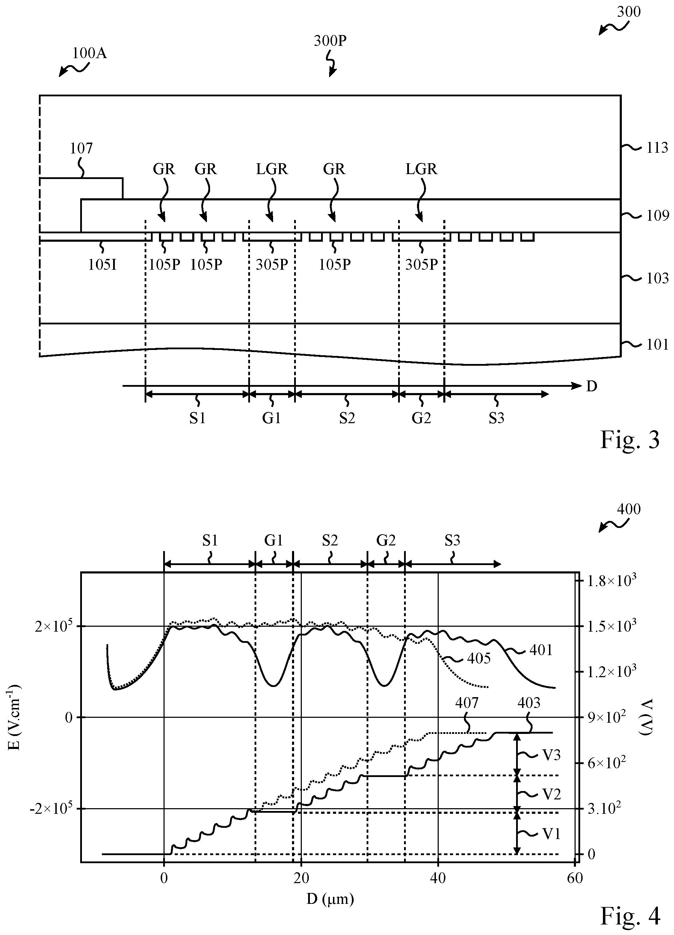

La figure 3 est une vue de détail, schématique et partielle, d'une région périphérique d'un composant vertical de puissance 300 selon un mode de réalisation. Dans l'exemple illustré, le composant vertical de puissance 300 est une diode JBS. Le composant vertical de puissance 300 de la figure 3 comprend des éléments communs avec le composant vertical de puissance 100 des figures 1A, 1B et 2. Ces éléments communs ne seront pas détaillés à nouveau ci-après. Le composant vertical de puissance 300 de la figure 3 diffère du composant vertical de puissance 100 des figures 1A, 1B et 2 en ce que le composant 300 comprend une région périphérique 300P analogue à la région périphérique 100P du composant 100 mais comportant, outre les groupes S1, S2 et S3 d'anneaux de limitation de champ GR comprenant les régions semiconductrices 105P, d'autres anneaux de limitation de champ (LGR), par exemple des anneaux de garde flottants, comprenant chacun une région semiconductrice 305P.

Les régions semiconductrices 105P et 305P sont par exemple concentriques et chaque région semiconductrice 305P est interposée latéralement entre deux groupes de régions semiconductrices 105P. En d'autres termes, chaque anneau de limitation de champ LGR est interposé latéralement entre deux groupes (S1 et S2, ou S2 et S3) d'anneaux de limitation de champ GR. Dans l'exemple représenté, les anneaux de limitation de champ LGR forment deux espaces, ou intervalles, G1 et G2 séparant respectivement le groupe S1 du groupe S2, et le groupe S2 du groupe S3.

Dans l'exemple illustré en figure 3, chaque région semiconductrice 305P s'étend verticalement dans l'épaisseur de la couche semiconductrice 103 depuis sa face opposée au substrat semiconducteur 101 (la face supérieure de la couche 103, dans l'orientation de la figure 3). Les régions semiconductrices 305P présentent une épaisseur strictement inférieure à celle de la couche semiconductrice 103, par exemple une épaisseur sensiblement égale à celle des régions semiconductrices 105P. Dans l'exemple illustré, les régions semiconductrices 305P font partie de la région périphérique 300P du composant vertical de puissance 300. Les régions semiconductrices 305P sont dopées du deuxième type de conductivité (le type P, dans cet exemple) . À titre d'exemple, les régions semiconductrices 305P présentent un niveau de dopage compris entre 1*10¹⁷ et 5*10²⁰ at./cm³ (dopage P⁺, dans le cas où le deuxième type de conductivité est le type P), par exemple un niveau de dopage sensiblement égal à celui des régions semiconductrices 105P. Les régions semiconductrices 305P sont par exemple formées par une étape d'implantation ionique, du côté de la face de la couche semiconductrice 103 opposée au substrat semiconducteur 101, suivie d'une étape de recuit. À titre d'exemple, les régions semiconductrices 105P et 305P sont formées simultanément.

Selon un mode de réalisation, chacune des régions semiconductrices 305P présente une largeur strictement supérieure à celle de chacune des régions semiconductrices 105P. Dit autrement, les anneaux de limitation de champ LGR présentent une largeur strictement supérieure à celle des anneaux de limitation de champ GR. À titre d'exemple, la largeur de chaque région semiconductrice 305P est au moins trois fois plus importante que celle de la région semiconductrice 105P la plus large. Dans l'exemple représenté en figure 3, les régions semiconductrices 305P présentent des dimensions identiques, aux dispersions de fabrication près.

Selon un mode de réalisation, la région isolante 109 est située sur et en contact mécanique avec toute la face supérieure de chacune des régions semiconductrices 305P. En particulier, le composant vertical de puissance 300 est dépourvu d'éléments électriquement conducteurs en contact avec les faces supérieures des régions semiconductrices 305P. Dans l'exemple illustré, la région isolante 109 est en outre située sur et en contact mécanique avec toute la face supérieure de chacune des régions semiconductrices 105P. En particulier, le composant vertical de puissance 300 est dépourvu d'éléments électriquement conducteurs en contact avec les faces supérieures des régions semiconductrices 105P.

À titre d'exemple, le nombre d'anneaux de limitation de champ LGR, ou le nombre de groupes d'anneaux de limitation de champ GR, est choisi en fonction d'un objectif de tenue en tension du composant vertical de puissance 300. Par ailleurs, le nombre d'anneaux de limitation de champ GR dans chaque groupe S1, S2, S3 est par exemple choisi en fonction d'une tension minimale de formation d'un arc électrique en cas de délamination, ou de décollement, dans le composant vertical de puissance 300. Cette tension minimale est par exemple donnée par la loi de Paschen appliquée au composant vertical de puissance 300. La géométrie, le nombre et la répartition des anneaux de limitation de champ GR sont définis de sorte que le champ électrique proche de l'interface entre les régions isolantes 109 et 113 soit sensiblement constant sur les groupes S1, S2 et S3.

Un avantage du composant vertical de puissance 300 tient au fait que la présence des anneaux LGR comprenant les régions semiconductrices 305P permet de réduire l'intensité du champ électrique présent au voisinage de l'interface entre les régions isolantes 109 et 113. Cela permet avantageusement d'éviter, ou de limiter, les risques de formation d'un arc électrique en cas de délamination, ou de décollement, dans le composant vertical de puissance 300.

La figure 4 est un graphique 400 illustrant, par des courbes 401 et 403, des variations de champ électrique (E), exprimé en volts par centimètre (V.cm⁻¹), et de potentiel électrostatique (V), exprimé en volts (V), respectivement, dans la région périphérique 300P du composant vertical de puissance 300 de la figure 3. À titre de comparaison, le graphique 400 illustre en outre, par des courbes en pointillé 405 et 407, des variations du champ électrique E et du potentiel électrostatique V, respectivement, dans la région périphérique 100P du composant vertical de puissance 100. Le graphique 400 traduit plus précisément des variations du champ électrique E dans la région isolante 109 du composant vertical de puissance 100 ou 300, par exemple au voisinage de l'interface avec la région isolante 113, et du potentiel électrostatique V dans le matériau semiconducteur, au voisinage de l'interface avec la région isolante 109. Ces variations sont représentées en fonction de la distance D.

Dans l'exemple représenté, la courbe 401 indique que le champ électrique E est sensiblement constant, et égal à environ 2*10⁵ V.cm⁻¹, à l'aplomb de chaque groupe S1, S2, S3 d'anneaux GR, et que le champ électrique E diminue fortement, par exemple d'un facteur deux ou trois, dans chaque espace G1, G2 situé à l'aplomb d'un anneau LGR. Dit autrement, les anneaux de limitation de champ LGR permettent de réduire le champ électrique E de moitié, de préférence d'au moins deux tiers, par rapport aux zones de champ constant. À titre de comparaison, la courbe 405 indique que le champ électrique E est sensiblement constant, et égal à environ 2*10⁵ V.cm⁻¹, le long de l'axe de distance D dans le cas du composant vertical de puissance 100.

Dans l'exemple illustré en figure 4, la courbe 403 indique que le potentiel électrostatique V croît d'une valeur V1 entre les deux extrémités du groupe S1 d'anneaux GR, d'une valeur V2 entre les deux extrémités du groupe S2 d'anneaux GR et d'une valeur V3 entre les deux extrémités du groupe S3 d'anneaux GR. Chacune des valeurs V1, V2 et V3 est par exemple strictement inférieure à la tension minimale à partir de laquelle un arc électrique est susceptible de se produire dans le composant vertical de puissance 300 en cas de délamination ou de décollement. À titre d'exemple, chaque valeur V1, V2, V3 est inférieure à 280 V, par exemple de l'ordre de 250 V, la somme des valeurs V1, V2 et V3 étant par exemple égale à environ 750 V. Par ailleurs, dans l'exemple représenté, le potentiel électrostatique V est sensiblement constant dans les espaces G1 et G2, la courbe 403 comprenant des plateaux correspondant à la position des anneaux LGR. À titre de comparaison, la courbe 407 est dépourvue de tels plateaux.

Comme cela est illustré par le graphique 400 de la figure 4, un avantage du composant vertical de puissance 300 tient au fait que la présence des anneaux de limitation de champ LGR, interposés latéralement entre les groupes S1, S2 et S3 d'anneaux de limitation de champ GR, permet de créer des zones de faible champ électrique empêchant la formation, en cas de délamination ou de décollement, d'arcs électriques aux effets délétères pour le fonctionnement du composant 300.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation décrits ne se limitent pas au cas dans lequel le composant vertical de puissance 300 est une diode JBS, mais s'appliquent de façon plus générale à tout type de composant vertical de puissance, par exemple une diode bipolaire, un transistor MOS (de l'anglais « Metal-Oxide-Semiconductor » - métal oxyde semiconducteur), un thyristor, etc. comprenant des anneaux de limitation de champ, par exemple à tout type de composant vertical de puissance susceptible d'être soumis à des tensions supérieures à 350 V entre ses électrodes de conduction. L'adaptation des modes de réalisation décrits à ces composants est à la portée de la personne du métier à partir des indications ci-dessus.

Enfin, la mise en oeuvre pratique des modes de réalisation et variantes décrits est à la portée de la personne du métier à partir des indications fonctionnelles données ci-dessus. En particulier, la personne du métier est capable d'adapter le nombre de groupes d'anneaux de limitation de champ GR, le nombre d'anneaux de limitation de champ GR dans chaque groupe d'anneaux de limitation de champ GR, et les dimensions latérales de chaque anneau de limitation de champ LGR en fonction de l'application. Par ailleurs, les modes de réalisation ne se limitent pas aux exemples de matériaux et de dimensions décrits.

## Revendications

1. Composant vertical de puissance (300) formé dans et sur un substrat semiconducteur (101) dopé d'un premier type de conductivité et revêtu, sur sa face supérieure, d'une couche semiconductrice (103) dopée du premier type de conductivité, le composant (300) comprenant :
- une région active (100A) ;
- des premier et deuxième groupes (S1, S2) de premiers anneaux (GR) concentriques de limitation de champ entourant la région active (100A), chaque premier anneau (GR) comprenant une première région semiconductrice (105P) dopée d'un deuxième type de conductivité, opposé au premier type de conductivité, s'étendant verticalement dans l'épaisseur de la couche semiconductrice (103) depuis sa face supérieure ;
- un deuxième anneau (LGR) de limitation de champ interposé latéralement entre les premier et deuxième groupes (S1, S2) de premiers anneaux (GR) de limitation de champ, le deuxième anneau (LGR) comprenant une deuxième région semiconductrice (305P) dopée du deuxième type de conductivité s'étendant verticalement dans l'épaisseur de la couche semiconductrice (103) depuis sa face supérieure, dans lequel la deuxième région semiconductrice (305P) présente une largeur au moins trois fois plus importante que celle de la première région semiconductrice (105P) la plus large ; et
- une première région isolante (109) située sur et en contact mécanique avec toute la face supérieure de la deuxième région semiconductrice (305P).

2. Composant (300) selon la revendication 1, dans lequel le deuxième anneau (LGR) permet de réduire au moins de moitié, de préférence d'au moins deux tiers, un champ électrique (E) présent au voisinage d'une interface entre la première région isolante (109), disposée sur et en contact avec la face supérieure de la couche semiconductrice (103), et une deuxième région isolante (113), située dans une région périphérique (100P) du composant vertical de puissance (300) .

3. Composant (300) selon la revendication 1, dans lequel le deuxième anneau (LGR) permet de réduire au moins de moitié, de préférence d'au moins deux tiers, un champ électrique (E) présent au voisinage d'une interface entre la première région isolante (109), disposée sur et en contact avec la face supérieure de la couche semiconductrice (103), et une résine de moulage d'un boîtier du composant vertical de puissance (300).

4. Composant (300) selon la revendication 1, 2 ou 3, dans lequel les premier et deuxième groupes (S1, S2) comprennent des nombres identiques de premiers anneaux (GR).

5. Composant (300) selon l'une quelconque des revendications 1 à 4, dans lequel les premiers et deuxième anneaux (GR, LGR) de limitation de champ sont des anneaux de garde flottants.

6. Composant (300) selon l'une quelconque des revendications 1 à 5, comprenant en outre au moins un troisième groupe (S3) de premiers anneaux (GR), et au moins un troisième anneau (LGR) de limitation de champ interposé entre le deuxième groupe (S2) de premiers anneaux et ledit au moins un troisième groupe (S3) de premiers anneaux.

7. Composant (300) selon l'une quelconque des revendications 1 à 6, dans lequel la couche semiconductrice (103) présente un niveau de dopage strictement inférieur à celui du substrat semiconducteur (101).

8. Composant (300) selon l'une quelconque des revendications 1 à 7, comprenant :
- une première électrode de conduction formée dans la région active (100A) et comprenant une région conductrice (107) située sur la couche semiconductrice (103) ; et
- une deuxième électrode de conduction disposée du côté d'une face du substrat semiconducteur (101) opposée à la couche semiconductrice.

9. Composant (300) selon l'une quelconque des revendications 1 à 8, dans lequel le substrat semiconducteur (101) est en silicium ou en carbure de silicium.

10. Composant (300) selon l'une quelconque des revendications 1 à 9, dans lequel le premier type de conductivité est N et le deuxième type de conductivité est P.

11. Composant (300) selon l'une quelconque des revendications 1 à 10, dans lequel le composant est une diode JBS.
